**Europäisches Patentamt**

**European Patent Office**

**Office européen des brevets**

(19)

(11) **EP 1 467 254 A1**

(12) # EUROPEAN PATENT APPLICATION

(43) Date of publication:
**13.10.2004 Bulletin 2004/42**

(51) Int Cl.$^7$: **G03F 7/20**

(21) Application number: **04252063.5**

(22) Date of filing: **07.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **07.04.2003 EP 03252182**

(71) Applicant: **ASML Netherlands B.V.**
**5504 DR Veldhoven (NL)**

(72) Inventors:
  • **Hansen, Steven George**
    **Phoenix AZ 85048 (US)**

  • **Flagello, Donis George**
    **Scottsdale AZ 85255 (US)**
  • **Klaaassen, Michel Francois Hubert**
    **5611 NJ Eindhoven (NL)**
  • **De Winter, Laurentius Cornelius**
    **5512 BX Vessem (NL)**
  • **Knols, Edwin Wilhelmus Marie**
    **5622 GE Eindhoven (NL)**

(74) Representative: **Leeming, John Gerard**
    **J.A. Kemp & Co.,**
    **14 South Square,**
    **Gray's Inn**
    **London WC1R 5JJ (GB)**

(54) **Lithographic apparatus and device manufacturing method**

(57)     A rectangular or bar-shaped, on-axis illumination mask with radiation polarized parallel to the length of the bar provides improved DOF and exposure latitude with less lens heating as compared to a circular monopole with equivalent σ.

Fig. 3A

**Description**

The present invention relates to device manufacturing methods using lithographic apparatus.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

It is well known that manipulation of the illumination of the mask in a lithography apparatus affects the projected (aerial) image and hence it is common to select an illumination mode that is optimum for a given pattern to be printed. The illumination mode may be selected to optimize critical dimension, depth of focus, exposure latitude or a combination of these and other parameters.

In a lithographic apparatus using Kohler illumination, the illumination mode is most often determined, and described, by defining the intensity distribution in a pupil plane of the illumination system. Position in the pupil plane corresponds to angle of incidence at the mask so that a uniform intensity in the pupil plane, up to a certain radius commonly referred to a sigma ($\sigma$, where $0 < \sigma < 1$), gives rise to illumination form all angles, up to a certain maximum determined by the $\sigma$ value. Known illumination modes include: conventional (uniform up to a certain $\sigma$ value), annular (defined by $\sigma_{inner}$ and $\sigma_{outer}$ values), dipole, quadrupole and more complex arrangements. Illumination modes consisting of (uniform) light areas on a dark background are conventionally described by describing the shape and placement of the light areas. For example, WO 02/05029 describes multipole illumination modes where the poles are in the form of chevrons and also suggests that multipole modes with round poles may be improved by making the poles square or rectangular. US 6,045,976 describes illumination modes involving bright lines extending across the pupil plane in parallel to and spaced from the X or Y axis. These modes are intended for exposure of line patterns which are parallel to the bright lines of the illumination mode.

Illumination modes may be formed in various ways. The $\sigma$ value of a conventional illumination mode can be controlled using a zoom lens whilst $\sigma_{inner}$ and $\sigma_{outer}$ values of an annular mode can be controlled using a zoom-axicon. More complex modes may be formed using a diaphragm with appropriate apertures in the pupil plane or by a diffractive optical element. The illumination system may comprise a rod-shaped reflective integrator for homogenizing the intensity distribution of radiation at the patterning means. The rod shaped integrator typically has a rectangular cross section and may be disposed along the optical axis of the illumination system at a position upstream of said pupil plane. Typically, said diffractive optical element is arranged to generate a preselected angular intensity distribution upstream of the integrator. This angular intensity distribution is transformed into a corresponding spatial intensity distribution in the pupil plane of the illumination system. Due to reflections in the rod integrator, the latter intensity distribution is symmetric with respect to the sides of said rectangular cross section.

To print very small, isolated gates - that is a pair of lines close together but isolated from other structures - it has been proposed to use an alternating phase shift mask (Alt-PSM) and a conventional illumination mode with a very low $\sigma$ value, e.g. 0.15. However, such a method still leaves room for improvement of the process latitude and the use of a small $\sigma$ value means the light is very localized in the illumination and projection systems which causes localized lens heating problems.

It is an object of the present invention to provide an improved method and apparatus for printing small isolated gates, for example, and in particular such a method and apparatus which provides improved process latitude and/or more uniform lens heating.

According to an aspect of the invention, there is provided a lithographic projection apparatus comprising:

- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate; characterized in that:

- said means for defining an intensity distribution imparts an on-axis, substantially rectilinear intensity distribution on the projection beam; and by polarizing means for imparting a linear polarization to the projection beam.

Where the intensity distribution is a rectangle or bar, the longer dimension of the rectangle is preferably parallel to the lines of the gates to be printed, which are normally aligned with the X or Y axis of the apparatus. Where the intensity distribution is a square, the square may be oriented such that its sides are parallel to the X and Y axes or such that its diagonals are parallel to the X and Y axes. The latter orientation may also be described as a diamond-shaped illumination mode and may be unpolarized. A cross-shaped intensity distribution may have the arms of the cross aligned with the X and Y axes or on the diagonals. The cross-shaped intensity distribution may also be advantageous without polarization. A rhomboid intensity distribution, that is with opposite sides parallel and equal but not all sides and angles equal, is also advantageous.

For a given area in the pupil plane, a rectilinear intensity distribution can provide the same depth of focus as a conventional, circular mode whilst distributing the radiation more evenly in the illumination and projection systems, reducing lens heating effects.

An on-axis illumination mode is, for the purposes of this invention, one in which the optical axis of the illumination system passes through the bright area of the pupil plane. The center of gravity of the bright area preferably lies on the optical axis but that is not essential.

The present invention is particularly advantageous when carrying out lithography using phase-shift masks (PSM).

The direction of polarization of the projection beam should be parallel to the lines to be printed and where the intensity distribution is rectangular, also parallel to the long sides of the rectangle. The use of polarized radiation in this way can provide an increase in exposure latitude of up to 70%.

In another aspect of the invention, the rectilinear intensity distribution has at least two elongate poles located off-axis, rather than a single pole located on-axis, and the direction of polarization is substantially parallel to the long direction of the poles. In a preferred embodiment of this aspect, there are four elongate poles - two oriented along a first direction and two oriented along a second direction substantially orthogonal to the first direction - the direction of polarization of the radiation in each pole being substantially parallel to the long direction of that pole.

Another aspect of the invention provides a lithographic projection apparatus comprising:

- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate; characterized in that:

- said means for defining an intensity distribution imparts an intensity distribution that is not symmetric in an interchange of two orthogonal axes; and by polarizing means for imparting a linear polarization the projection beam.

The intensity distribution not being symmetric about an interchange of orthogonal axes means that it is not the same in the X direction as in the Y. This means that the shape of the intensity distribution can be separately optimized for features aligned in the X and Y directions.

According to a further aspect of the invention there is provided a device manufacturing method comprising the steps of:

- providing a substrate;
- providing a projection beam of radiation using an illumination system;
- using patterning means to impart the projection beam with a pattern in its cross-section; and
- projecting the patterned beam of radiation onto a target portion of the substrate, characterized in that:

- said desired intensity distribution comprises an on-axis rectilinear intensity distribution on the projection beam; and by the further step of:

- linearly polarizing said projection beam.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm).

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:

Figure 1 depicts a lithographic projection apparatus according to an embodiment of the invention;
Figures 2A to B are sketches illustrating the principle of chromeless phase edge masks, alternating-phase shift masks and chromeless phase lithography;
Figure 3A illustrates an illumination mode according to a first embodiment of the invention whilst Figure 3B illustrates a prior art illumination mode for comparison;
Figure 4 illustrates the average σ values of the illumination modes of Figures 3A and 3B;
Figure 5 is a graph of exposure latitude vs. depth of focus for various illumination modes according to the first embodiment of the invention and according to the prior art;
Figure 6 is a graph of exposure latitude vs. depth of focus for an illumination mode according to the first embodiment of the invention with and without polarization;
Figures 7 to 11 illustrate illumination modes according to second through sixth embodiments according to the present invention; and
Figures 12A and 12B depict pupil intensity distributions in a seventh embodiment of the invention with a diffractive optical element at different angles.

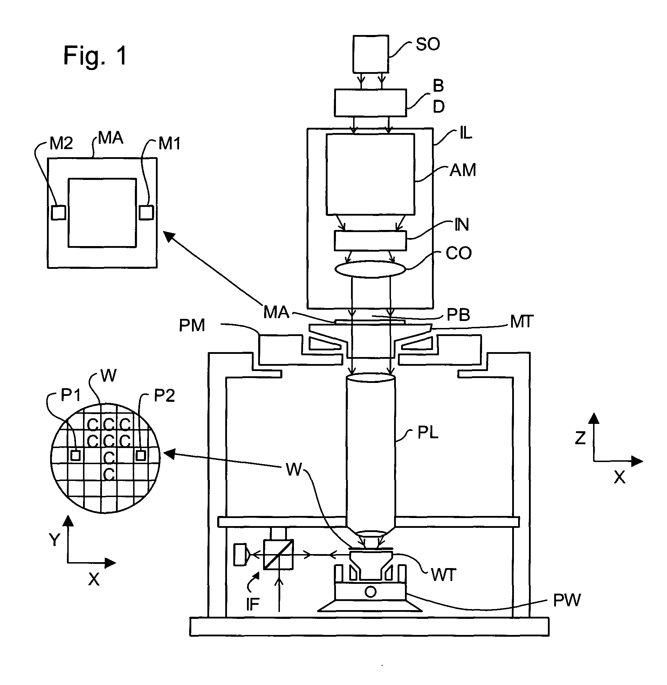

Figure 1 schematically depicts a lithographic apparatus according to a particular embodiment of the invention. The apparatus comprises:

- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

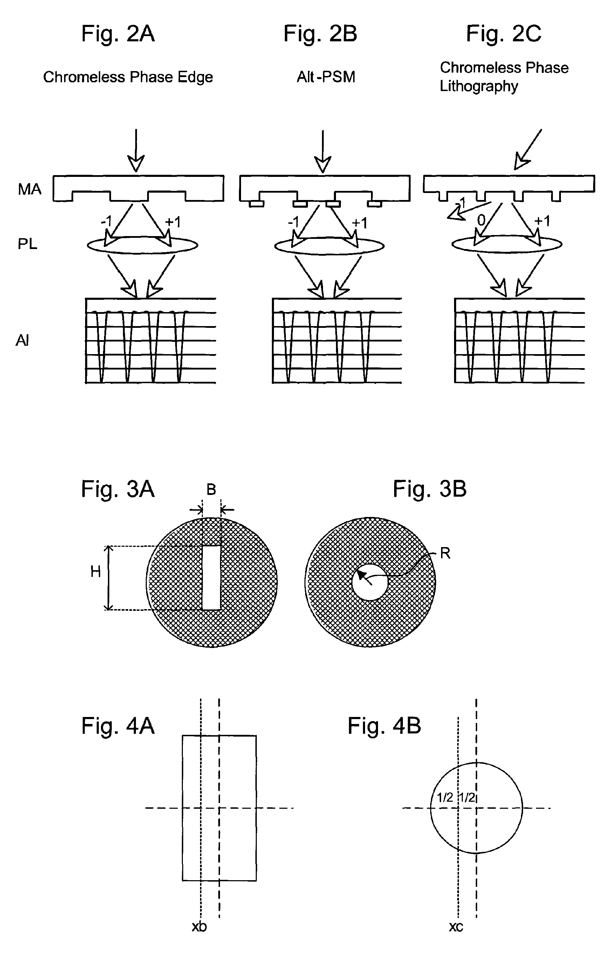

The above described lithographic apparatus an be used with various different types of mask. The most basic type of mask is a transparent plate, e.g. of quartz glass, on which an opaque layer, e.g. of chrome, is provided to define the pattern. More advanced types of mask modulate the thickness of the mask to vary the phase of the projection beam to various effects. Figures 2A to C illustrate the principles of operation of three such types of mask: Chromeless Phase Edge, Alternating Phase Shift masks (Alt-PSM) and Chromeless phase lithography.

In Chromeless Phase Edge lithography, the mask MA is illuminated normally and has a pattern of thickness variations forming a phase grating. The + and - first orders are captured by the projection system PL and interfere to form the aerial image AI, which has a periodicity higher than that of the mask.

Lithography using an Alternating Phase Shift Mask appears similar to Chromeless Phase Edge lithography but instead the pattern is defined in chrome on the mask. Underlying thickness variations in the mask are provided so that the phase of radiation transmitted through adjacent features alternates to prevent constructive interference between adjacent features resulting in the printing of ghost lines.

Chromeless Phase Lithography utilizes inclined illumination and interference between the $0^{th}$ and one $1^{st}$ order to form an image.

In the present invention, to print very narrow gates, e.g. of 32nm width, a rectangular monopole illumination mode is used, as shown in Figure 3A. The rectangular monopole is effectively identical to a circular monopole (Figure 3B) with very low $\sigma$ if the following condition is met:

$$0.404^*R = B/4 \qquad (1)$$

where R is the radius of the circular monopole expressed in units of $\sigma$, and B is the width of the bar, also in units of $\sigma$.

This condition can be derived by considering the average $\sigma$ values xb, xc for the two illumination modes, as shown in Figures 4A and B. The two modes are considered equivalent if their average $\sigma$ values are equal. The average $\sigma$ value is defined as the first moment of the intensity distribution along the line perpendicular to the feature orientation. This is equivalent to the expectation value <x> for lines parallel to the y axis and <y> for lines parallel to the x axis.

The height H of the bar has little impact on the exposure parameters.

The rectangular monopole is advantageous as compared to the equivalent circular monopole because the projection beam will be less localized in the projection system leading to less localized lens heating and hence a reduction in distortion caused by lens heating.

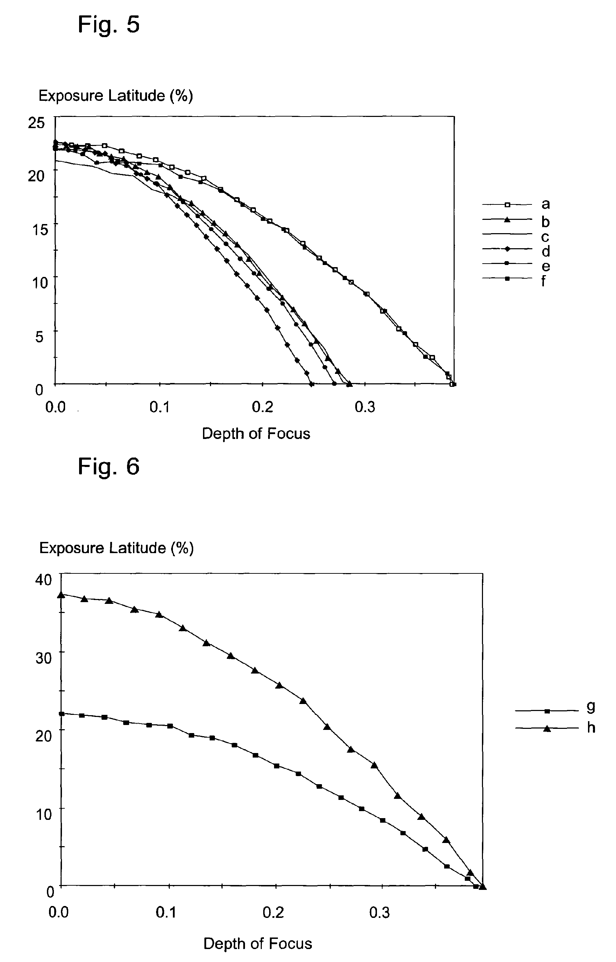

Figures 5 and 6 are graphs of exposure latitude vs. depth of focus (DOF) and demonstrate the advantages of the present invention. Both graphs represent the results of simulations carried out in a Solid-C™ model of a lithographic apparatus with NA=0.85, 193nm exposure radiation, an ALT-PSM mask representing gates of 32nm width and 160nm pitch (at substrate level). The illumination modes for curves A-F in Figure 5 were as follows:

  a: circular monopole, $\sigma$ = 0.10
  b: bar, B = 0.20, H = 0.80
  c: bar, B = 0.20, H = 0.40
  d: circular monopole, $\sigma$ = 0.15
  e: bar, B = 0.24, H = 1.0
  f: bar, B = 0.16, H = 1.0

This graph show that the same exposure latitude and depth of focus can be achieved with a bar as with a monopole of low-$\sigma$, provided the rule that B = 1.6*R is followed. Furthermore, the value of H has little influence on process latitude.

Figure 6 shows the effect of polarization - curve g is for bar illumination with B = 0.16 and H = 1.0 whilst curve h is for the same illumination but with the radiation s-polarized. A 70% improvement in exposure latitude can be seen.

One way of effecting such an illumination mode is to use a conventional illumination mode with $\sigma$ = 0.5 and use masking blades in a pupil plane of the radiation system to reduce the illumination down to a rectangle of the desired shape and a polarizer in the blade aperture. Such an arrangement would provide an efficiency $\varepsilon$ defined by:

$$\varepsilon = \frac{2\sqrt{R^2 - (B/2)^2}.B}{\pi.R^2}2 \qquad (2)$$

Where B is the width of the bar and R the radius of the conventional illumination setting which is bladed down. Both are in units of $\sigma$.

For the specific example of B = 0.16 and R = 0.50, $\varepsilon$ = 20%, which compares favorably with an efficiency of 16% as would be obtained for a monopole of $\sigma$ = 0.10 obtained by blading down a setting of $\sigma$ = 0.25. The local heating effect is equivalent to a monopole of σ = 0.23.

The appropriate illumination mode and dimensions for a given exposure can be determined for a given pitch, p, wavelength, λ, of the exposure radiation and numeric aperture, NA, of the projection system. Dimensions of optimum illumination modes of different shape, where 100% of the $0^{th}$ and $1^{st}$ orders are captured by the projection system and the area of the $0^{th}$ order within the illuminator pupil is maximum are given by:

Circle:

$$R = 1 - \kappa \tag{3}$$

Rectangle:

$$B = \frac{1}{2}.\sqrt{\kappa^2 + 8} - \frac{3.\kappa}{2} \text{ and } H = \sqrt{1 - \left(\kappa + \frac{b}{2}\right)^2} \tag{4}$$

Ellipse:

$$H = \sqrt{1 - \kappa^2} \text{ and } B = 2.(1-\kappa) \tag{5}$$

where:

$$\kappa = \frac{\lambda}{2p.NA} \tag{6}$$

As a guideline, an upper limit to the width of a bar can be set as:

$$B < 2 - \frac{\lambda}{p.NA} \tag{7}$$

These expressions can be derived using simple mathematical analysis.

It should be noted that where the radiation source emits a polarized beam, e.g. an excimer laser, rather than providing a polarizer, a normally-present de-polarizer may be removed and, if necessary, replaced by a suitable retarder (wave plate) to rotate the polarization to the desired orientation.

Embodiment 2

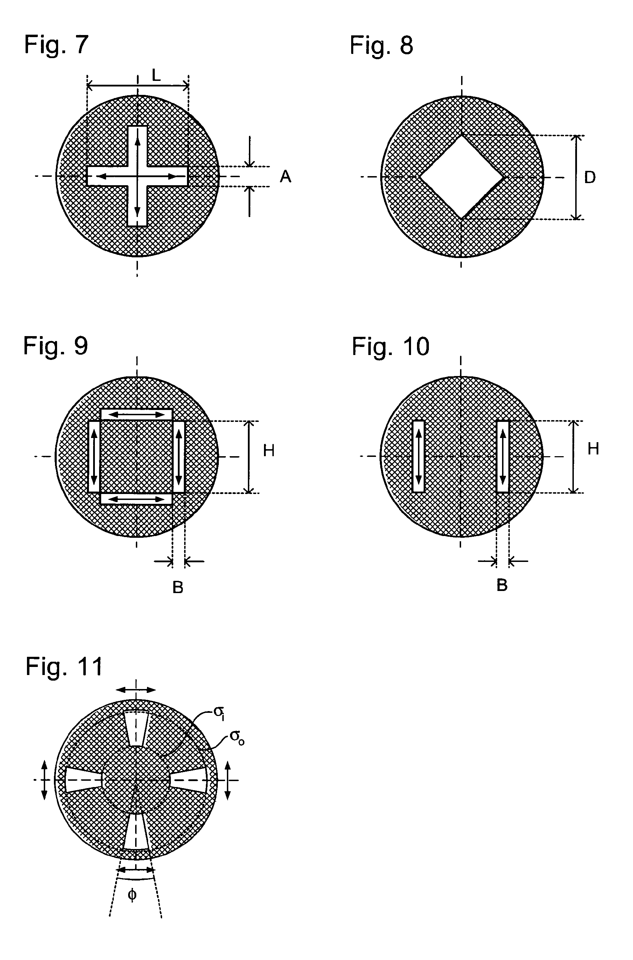

A second embodiment is the same as the first embodiment except that it uses a cross-shaped on-axis monopole illumination mode, as shown in Figure 7. A cross-shaped illumination mode has lower average σ value than a circular monopole of equivalent area, or conversely larger area for a given average σ. The cross also has better depth of focus and avoids catastrophic defocus failure as can occur with circular monopoles. Furthermore, the cross is applicable for patterns including gates oriented in two orthogonal directions. The radiation in each arm of the cross is preferably polarized parallel to the elongate direction of the arm, as indicated by arrows in the cross.

The cross-shaped illumination mode is preferably symmetric about two axes and thence can be characterized by two parameters - the arm width A and the length L. Appropriate values for A and L can be determined in the same way as B and H are determined in the first embodiment. Preferably, the horizontal arm (bar) dimensions are determined for the horizontal features in the pattern and the vertical arm dimensions for the vertical features in the patterns. This may lead to arms of different lengths and/or widths.

Embodiment 3

A third embodiment is the same as the first embodiment except that it uses a diamond-shaped (rhomboid) on-axis monopole illumination mode, as shown in Figure 8. A diamond shape with diameter D has a greater area but the same average σ as a cross with L = D. Hence the diamond has greater efficiency, allowing more rapid exposures (i.e. greater throughput) and less local lens heating.

Embodiment 4

A fourth embodiment is the same as the first embodiment except that it uses an off-axis rectangular intensity distribution, as shown in Figure 9.

The intensity distribution comprises four off-axis rectangular poles (bars) in each of which the radiation is polarized parallel to the length of the bar. The bars are arranged to form a square centered on the optical axis and may be characterized by their length, H, and width, B. The illumination mode, which may be referred to as a "quadrubar", provides an unexpectedly high process latitude for both isolated and periodic features without assist features, especially when using a chromeless phase lithography mask. Advantages are also obtained with binary and attenuated phase shift masks.

An equivalent setting to the quadrubar can be achieved in an existing apparatus using a diffractive optical element to define a quadrupole illumination setting and setting the zoom-axicon to generate a narrow annular illumination setting. The resultant poles are like narrow arcs and are in many cases acceptable approximations to the linear bars of this embodiment.

Embodiment 5

A fifth embodiment is the same as the fourth embodiment except that it uses a dipole illumination mode, as shown in Figure 10. This "duobar" mode is applicable for patterns having features aligned in one direction.

Equivalent Illumination Modes

As discussed above, two illumination modes may be considered equivalent for imaging purposes if they have equal average $\sigma$ values, average $\sigma$ being defined as the first moment of intensity along the direction perpendicular to the feature orientation. Average $\sigma$ may also be referred to as center $\sigma$ or $\sigma_C$. It is therefore possible to derive mathematically the dimensions of other illumination modes that would be equivalent to a given circular monopole of radius $\sigma$. This leads to the following results:

Table 1:

|  | Circle | Bar | Diamond | Square | Cross |
|---|---|---|---|---|---|
| Exposure | single | double | single | single | single |
| Polarization | unpol. | along bar | unpol. | unpol. | along bars |
| Metric | R | B | B | B | B |
| Center sigma | 0.404*R | 0.25*B | 0.207*B | 0.25*B | NA |
| Area | $\pi.R^2$ | B.H | $B^2$ | $B^2$ | $2.B.H-B^2$ |
| Center sigma / area | 0.129 / R | 0.25 / H | 0.207 / B | 0.25 / B | NA |
| metric @ 0.1 | 0.15 | 0.24 | 0.29 | 0.24 | NA |
| area @ 0.15 | 2.25% | 8*H% | 2.73% | 1.83% | NA |
| Typical area | 2.25% | 8% | 2.73% | 1.83% | 13.5% |
| Area is relative to total pupil filling | | | | | |

Embodiment 6

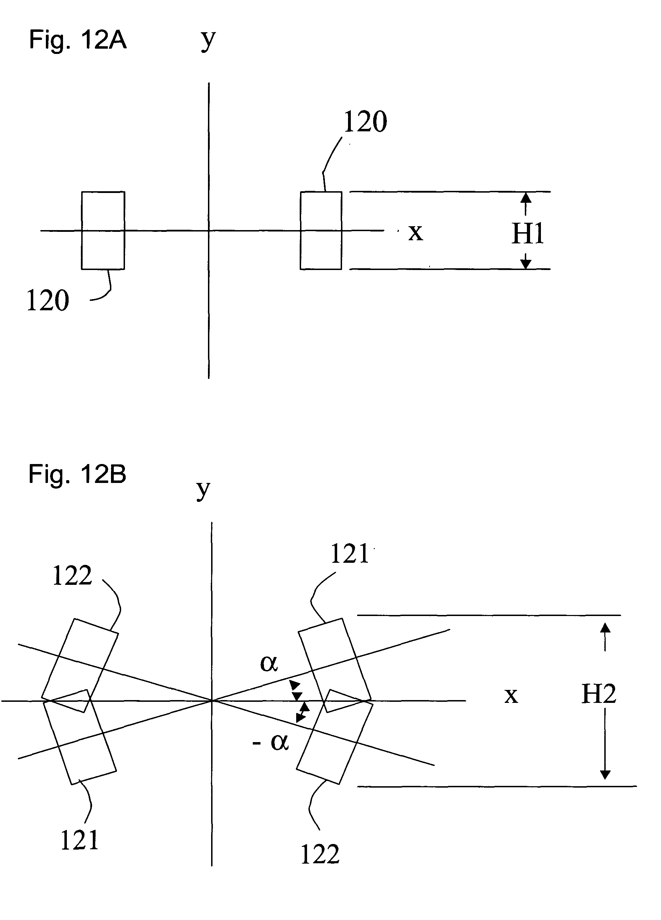

A sixth embodiment is the same as the first embodiment except that it uses a quadrupole illumination mode, as shown in Figure 11. For a given total area, this illumination mode can provide a superior depth of focus but inferior exposure latitude than a conventional circular monopole.

The quadrupole mode is effectively four parts of an annular mode and so can be characterized by inner and outer sigma values, $\sigma_1$ and $\sigma_0$, as well as a sector angle $\phi$. Values of $\sigma_1 = 0.40$, $\sigma_0 = 0.80$ and $\phi = 20°$ give a mode equivalent to a circular monopole of $\sigma = 0.30$. Polarization of the light in the four poles is indicated by the arrows outside the circle.

Embodiment 7

In any of the embodiments described above the illumination system may comprise a rod shaped reflective integrator for homogenizing the intensity distribution of radiation at the patterning means, as explained above. The illumination system may further comprise a diffractive optical element ("DOE") arranged to generate a preselected circular or rectangular shaped multipole angular intensity distribution upstream of the integrator. In any of the fourth, fifth and sixth embodiments, the length of substantially bar-shaped poles can conveniently be adjusted by applying a rotation to said diffractive optical element around an axis parallel to the optical axis of the illumination system. The angular intensity distribution generated by the diffractive optical element is transformed into a corresponding spatial intensity distribution in the pupil plane of the illumination system. Due to reflections in the rod integrator, the latter intensity distribution is symmetric with respect to the sides of said rectangular cross section. Hereafter, these sides are assumed to define x and y directions of an orthogonal system of x,y-axes.

Figure 12a shows the pupil intensity distribution downstream of the integrator when a DOE for duo-bar dipole illumination in a nominal rotational orientation is used (as an optical element for defining a corresponding angular intensity distribution upstream of the integrator). The duo-bar poles 120 with length H1 are centered at the x-axis. In Figure 12b the intensity distribution in the pupil is shown which results from said DOE being rotated over an angle $\alpha$. Due to reflections in the integrator rod (at the sides parallel to the y-axis), the resulting intensity distribution in the pupil downstream of the integrator is a sum of poles 121 rotated over an angle $\alpha$ and poles 122 rotated over an angle $-\alpha$, and symmetric with respect to the y-axis. Effectively, the length of the resulting duo-bar poles is H2, which is larger than H1. The length H2 can be tuned in accordance with the rotation $\alpha$ of the DOE. In principle, the adjustment can be applied as well to a DOE which, in a nominal rotational orientation is used to create, for example, square or circular poles. The adjustment has substantially a similar effect in that an elongation (in accordance with the rotation angle $\alpha$) of the poles is realized in the pupil plane of the illumination system.

While specific embodiments of the invention have been described above, it will be appreciated that the invention may be practiced otherwise than as described. The description is not intended to limit the invention.

**Claims**

1. A lithographic apparatus comprising:

   - an illumination system for providing a projection beam of radiation;
   - a support structure for supporting patterning means, the patterning means serving to impart the projection beam with a pattern in its cross-section;
   - a substrate table for holding a substrate; and
   - a projection system for projecting the patterned beam onto a target portion of the substrate,

     **characterized in that** :

   - said means for defining an intensity distribution imparts an on-axis, substantially rectilinear intensity distribution on the projection beam; and by
   - polarizing means for imparting a linear polarization to the projection beam.

2. Apparatus according to claim 1 wherein said intensity distribution is a rectangle having an aspect ratio not equal to 1, and the longer dimension of the rectangle is parallel to the X or Y axis of the apparatus.

3. Apparatus according to claim 2 wherein said linear polarization is substantially parallel to the longer dimension of the rectangle.

4. Apparatus according to claim 1 wherein said intensity distribution is a square.

5. Apparatus according to claim 4 wherein said intensity distribution is oriented such that the sides of the square are parallel to the X and Y axes.

6. Apparatus according to claim 4 wherein said intensity distribution is oriented such that the diagonals of the square are parallel to the X and Y axes.

7. Apparatus according to claim 1 wherein said intensity distribution is cross-shaped.

8. Apparatus according to claim 7 wherein said intensity distribution is oriented such that the arms of the cross are aligned with the X and Y axes of the apparatus.

9. Apparatus according to any one of the preceding claims wherein the center of said intensity distribution lies on the optical axis of the illumination system.

10. Apparatus according to any one of the preceding claims further comprising a phase-shift mask as said patterning means.

11. Apparatus according to claim 1 wherein the rectilinear intensity distribution has at least two elongate poles located off-axis, rather than a single pole located on-axis, and the direction of polarization is substantially parallel to the long direction of the poles.

12. Apparatus according to claim 11 wherein said rectilinear intensity distribution has four elongate poles, two of which are oriented along a first direction and two of which are oriented along a second direction substantially orthogonal to the first direction, the direction of polarization of the radiation in each pole being substantially parallel to the long direction of that pole.

13. Apparatus according to claim 11 or 12, wherein said means for imparting an intensity distribution comprises a diffractive optical element for generating a dipole or a quadrupole angular intensity distribution which is rotatable around an axis parallel to an optical axis of the radiation system and further comprises a rod-type optical integrator.

14. Apparatus according to any one of claims 1 to 12 wherein said means for imparting an intensity distribution comprises a set of moveable blades.

15. Apparatus according to any one of claims 1 to 12 wherein said means for imparting an intensity distribution comprises a diaphragm having an aperture or apertures corresponding to said intensity distribution.

16. Apparatus according to claim 15 wherein said polarizing means comprises polarizers mounted in the or each aperture of said diaphragm.

17. Apparatus according to any one of claims 1 to 15 wherein means for polarizing comprises a radiation source that emits a linearly polarized beam.

18. A lithographic projection apparatus comprising:

- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,

    **characterized in that**:

- said means for defining an intensity distribution imparts an intensity distribution that is not symmetric in an interchange of two orthogonal axes; and by polarizing means for imparting a linear polarization the projection beam.

19. A device manufacturing method comprising the steps of:

- providing a substrate;
- providing a projection beam of radiation using an illumination system;
- using patterning means to impart the projection beam with a pattern in its cross-section; and
- projecting the patterned beam of radiation onto a target portion of the substrate, **characterized in that**
- said desired intensity distribution comprises an on-axis rectilinear intensity distribution; and by the further step of:

- linearly polarizing said projection beam.

20. A method according to claim 19 wherein in said step of linearly polarizing, the direction of the linear polarization imparted to the beam is substantially parallel to lines of said pattern.

Fig. 1

# Fig. 2A

Chromeless Phase Edge

# Fig. 2B

Alt -PSM

# Fig. 2C

Chromeless Phase
Lithography

# Fig. 3A

# Fig. 3B

# Fig. 4A

# Fig. 4B

## Fig. 5

Exposure Latitude (%)

## Fig. 6

Exposure Latitude (%)

Fig. 7

Fig. 8

Fig. 9

Fig. 10

Fig. 11

Fig. 12A

Fig. 12B

EP 1 467 254 A1

**European Patent Office**

## EUROPEAN SEARCH REPORT

Application Number

EP 04 25 2063

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | WO 00/55675 A (ROCHESTER INST OF TECHNOLOGY) 21 September 2000 (2000-09-21) * abstract * * figures 3A-3C * * page 6, line 12 - page 6, line 22 * * page 7, line 11 - page 8, line 19 * * page 11, line 22 - line 31 * | 1-20 | G03F7/20 |
| Y | US 5 442 184 A (CHEN GONG ET AL) 15 August 1995 (1995-08-15) * abstract * * figure 1 * * column 1, line 46 - column 1, line 49 * * column 2, line 36 - column 2, line 59 * * column 3, line 1 - column 3, line 36 * | 1-20 | |
| A | US 6 268 908 B1 (COLE DANIEL C ET AL) 31 July 2001 (2001-07-31) * abstract * * figures 1-3,7-17 * * column 1, line 1 - column 1, line 10 * * column 1, line 64 - column 2, line 10 * * column 2, line 23 - column 2, line 40 * * column 3, line 36 - column 4, line 23 * * column 5, line 18 - column 5, line 45 * | 1,18,19 | TECHNICAL FIELDS SEARCHED (Int.Cl.7) G02B G03F H01L |
| A,D | US 6 045 976 A (ASAI SATORU ET AL) 4 April 2000 (2000-04-04) * abstract * * figures 1,3,6,8,11 * * column 1, line 30 - column 1, line 46 * * column 8, line 45 - column 8, line 58 * * column 10, line 18 - column 10, line 23 * * column 9, line 14 - column 9, line 19 * * column 10, line 54 - column 10, line 63 * * column 12, line 14 - column 12, line 22 * | 1,18,19 | |

The present search report has been drawn up for all claims

| Place of search | Date of completion of the search | Examiner |
|---|---|---|
| The Hague | 9 July 2004 | Andersen, O |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

17

EP 1 467 254 A1

**ANNEX TO THE EUROPEAN SEARCH REPORT
ON EUROPEAN PATENT APPLICATION NO.**                     EP 04 25 2063

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2004

| Patent document cited in search report | | Publication date | Patent family member(s) | | Publication date |
|---|---|---|---|---|---|
| WO 0055675 | A | 21-09-2000 | AU | 4015500 A | 04-10-2000 |
| | | | WO | 0055675 A1 | 21-09-2000 |
| | | | US | 6556361 B1 | 29-04-2003 |
| US 5442184 | A | 15-08-1995 | JP | 7288222 A | 31-10-1995 |
| US 6268908 | B1 | 31-07-2001 | NONE | | |
| US 6045976 | A | 04-04-2000 | JP | 2848425 B2 | 20-01-1999 |
| | | | JP | 5335213 A | 17-12-1993 |
| | | | JP | 5335214 A | 17-12-1993 |
| | | | JP | 3230014 B2 | 19-11-2001 |
| | | | JP | 6005489 A | 14-01-1994 |
| | | | JP | 3330648 B2 | 30-09-2002 |
| | | | JP | 6120119 A | 28-04-1994 |
| | | | JP | 6275493 A | 30-09-1994 |
| | | | US | 5607821 A | 04-03-1997 |
| | | | US | 6420094 B1 | 16-07-2002 |
| | | | EP | 0573281 A2 | 08-12-1993 |
| | | | KR | 136746 B1 | 24-04-1998 |
| | | | KR | 9614231 B1 | 14-10-1996 |
| | | | KR | 136800 B1 | 24-04-1998 |
| | | | US | 5465220 A | 07-11-1995 |

EPO FORM P0459

For more details about this annex : see Official Journal of the European Patent Office, No. 12/82

18